# EUROPEAN PATENT SPECIFICATION

(11) **EP 1 804 562 B1**
(45) Date of publication and mention of the grant of the patent: **17.10.2012**
(21) Application number: 05793224.6
(22) Date of filing: 14.10.2005
(51) Int. Cl.: H05K 3/46, H01L 23/12

(54) **COMPOSITE MULTILAYER SUBSTRATE AND ITS MANUFACTURING METHOD**
ZUSAMMENGESETZTES MEHRSCHICHTIGES SUBSTRAT UND VERFAHREN ZU SEINER HERSTELLUNG
SUBSTRAT MULTICOUCHE COMPOSITE ET SON PROCÉDÉ DE FABRICATION

(30) Priority: 22.10.2004 JP 2004308322
(43) Date of publication of application: 04.07.2007
(73) Proprietor: MURATA MANUFACTURING CO., LTD., Nagaokakyo-shi, Kyoto 617-8555 (JP)
(72) Inventor: OGAWA, Nobuaki, Kyoto 617-8555 (JP); NISHIZAWA, Yoshihiko, Kyoto 617-8555 (JP)
(74) Representative: Schoppe, Fritz
(86) International application number: PCT/JP2005/018937
(87) International publication number: WO 2006/043474

(56) References cited:
- JP-A- 11 260 964
- JP-A- 11 317 473
- JP-A- 2003 304 065
- JP-A- 2003 309 213

## Description

### Technical Field

The present invention relates to hybrid multilayer substrates and methods for manufacturing the same, and more particularly, relates to a highly reliable hybrid multilayer substrate having a cavity in which an electronic component is mounted with high accuracy, and to a method for manufacturing the hybrid multilayer substrate.

### Background Art

Heretofore, as this type of hybrid multilayer substrate, for example, a wiring substrate having a cavity disclosed in Patent Document 1 may be mentioned. This wiring substrate is formed of a ceramic core substrate having a penetrating hole, a resin insulating layer which is formed on the bottom surface of this ceramic core substrate and which blocks up the penetrating hole to form a cavity, an IC chip mounted in the cavity formed by the resin insulating layer, and a filling material which is filled around the IC chip to seal it in the cavity.

When the above wiring substrate is manufactured, after the ceramic core substrate having a penetrating hole is formed, the IC chip is aligned in the penetrating hole of the ceramic core substrate, and the filling material is then filled in a gap between the IC chip and the penetrating hole so as to unite the IC chip and the ceramic core substrate in the penetrating hole. Next, by a conventional known method, a resin insulating layer having via holes is formed on the rear surface of the ceramic core substrate.

Patent Document 1: Japanese Unexamined Patent Application Publication No. 2003-309213

### Disclosure of Invention

### Problems to be Solved by the Invention

However, as is the case of the wiring substrate disclosed in Patent Document 1, since the resin insulating layer having via holes is formed for the IC chip fixed in the penetrating hole of the ceramic core substrate by the filling material, and a self-alignment function of the IC chip cannot be used in mounting, terminals of the IC chip and the via holes (electrodes) of the resin insulating layer cannot be easily disposed without causing any problems, and as a result, it is difficult to obtain electrical conduction between the IC chip and the electrodes formed in the resin insulating layer. Furthermore, since IC chips have been multifunctionalized in recent year, in ICs for flip-chip assembly, the pitch between terminals is decreased, the size of bumps is decreased, and the number of pins is increased; hence, as a result, it becomes increasingly difficult to obtain electrical conduction between the IC chip and the electrodes formed in the resin insulating layer.

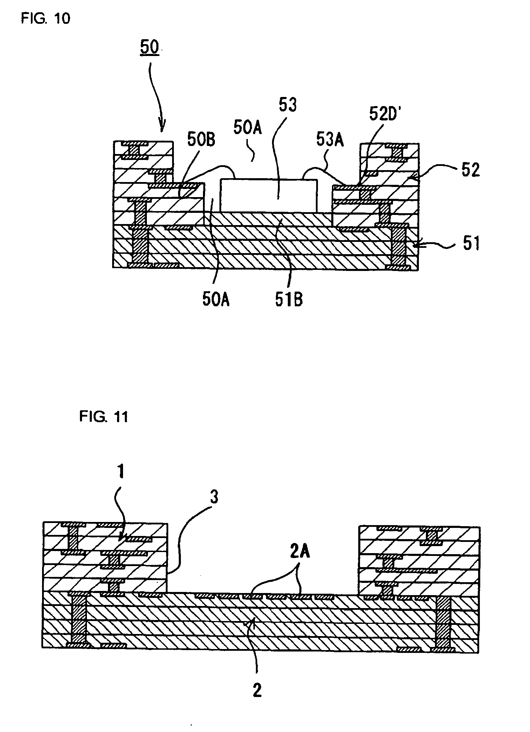

In order to use the self-alignment function of the IC chip, it is necessary to form a cavity 3 beforehand by thermocompression bonding of a resin insulating layer 2 having electrodes 2A to a ceramic substrate 1 having a penetrating hole as shown in Fig. 11. Furthermore, concomitant with the increase in the number of pins because of the narrower pitch and smaller bumps of an IC chip, the electrodes 2A must be formed with high accuracy in the cavity 3 so as to reduce the shift in position of the electrodes 2A as small as possible.

However, as shown in Fig. 11, when the resin insulating layer 2 is bonded to the ceramic substrate 1 by thermocompression bonding, the resin insulating layer 2 flows during the thermocompression bonding, the electrodes 2A located in the cavity 3 are shifted in the horizontal direction thereby, and hence it is difficult to form the electrodes 2A with high accuracy. This tendency becomes apparent as the number of films which form the resin insulating layer 2 is increased, and as a result, the reliability of connection may not be ensured in some cases.

JP 2003-309213 A describes a wiring board which houses an IC chip therein and is hardly deformed by heat. The wiring board comprises a ceramic core substrate which is made of ceramic and has a through hole. In the through hole, the IC chip is stored with a connection face formed with IC terminals faced toward a core rear face. A space between the through hole and the IC chip is filled with a filler. A resin insulation layer is deposited above the core rear face. On the surface of the resin insulation layer, a plurality of terminals are formed which have continuities with the IC terminals of the IC chip and are exposed to the outside.

### SUMMARY OF THE INVENTION

An object of the present invention is to provide a hybrid multilayer substrate and a method for manufacturing the same, the hybridmultilayer substrate having high arrangement accuracy of terminal electrodes and the like provided in the bottom surface of the cavity and being capable of significantly improving the reliability in connection with a mounted component.

This object is achieved by a method of claim 1, and by a substrate of claim 10.

### Means for Solving the Problems

In accordance with Claim 1 of the present invention, there is provided a method for manufacturing a hybrid multilayer substrate having a cavity in a laminate structure made of a resin portion and a ceramic substrate, which comprises the steps of: forming a resin portion having a protrusion part and a ceramic substrate having a penetrating hole; and bonding the resin portion to the ceramic substrate so as to fit the protrusion part of the resin portion to an end part of the penetrating hole of the ceramic substrate the resin portion. Accordingly, the ceramic substrate and the resin portion are united to form a cavity using an upper surface of the protrusion part as a bottom surface.

In addition, the method for manufacturing a hybrid multilayer substrate, which is described in Claim 2 of the present invention, is in accordance with Claim 1 of the present invention, in which the resin portion and the ceramic substrate are compression-bonded to each other.

In addition, the method for manufacturing a hybrid multilayer substrate, which is described in Claim 3 of the present invention, is in accordance with Claim 1 or 2 of the present invention, and further comprises the step of placing a first chip type electronic component in the cavity.

In addition, the method for manufacturing a hybrid multilayer substrate, which is described in Claim 4 of the present invention, is in accordance with Claim 3 of the present invention, and further comprises the step of sealing the first chip type electronic component placed in the cavity with a resin.

In addition, the method for manufacturing a hybrid multilayer substrate, which is described in Claim 5 of the present invention, is in accordance with one of Claims 1 to 4 of the present invention, in which the ceramic substrate is formed as a ceramic multilayer substrate composed of ceramic layers laminated to each other, and in which a predetermined conductive pattern is formed inside the ceramic multilayer substrate and on a surface thereof.

In addition, the method for manufacturing a hybrid multilayer substrate, which is described in Claim 6 of the present invention, is in accordance with Claim 5 of the present invention, in which the ceramic layers are formed using a low temperature sintered ceramic, and for the conductive pattern, a conductive material primarily composed of silver or copper is used.

In addition, the method for manufacturing a hybrid multilayer substrate, which is described in Claim 7 of the present invention, is in accordance with Claim 5 or 6 of the present invention, in which a terminal electrode is formed in the surface of the resin portion opposite to the surface bonded to the ceramic multilayer substrate, and this terminal electrode is connected to the conductive pattern formed for the ceramic multilayer substrate via a via conductor formed in the resin portion.

In addition, the method for manufacturing a hybrid multilayer substrate, which is described in Claim 8 of the present invention, is in accordance with one of Claims 1 to 7 of the present invention, wherein a region, in which a conductive pattern is not formed at the interface between the resin portion and the ceramic substrate and on the bottom surface of the cavity, is formed to be extended from an inside wall surface of the cavity, which is used as the center, to a position 150 µm or more apart therefrom in every direction.

In addition, the method for manufacturing a hybrid multilayer substrate, which is described in Claim 9 of the present invention, is in accordance with one of Claims 3 to 8 of the present invention, and further comprises the step of placing a second chip type electronic component in the resin portion.

In addition, in accordance with Claim 10 of the present invention, there is provided a hybrid multilayer substrate having a cavity in a laminate structure made of a resin portion and a ceramic substrate, in which the resin portion has a protrusion part and the ceramic substrate has a penetrating hole, and the cavity is formed of an upper surface of the protrusion part of the resin portion and a wall surface of the penetrating hole of the ceramic substrate.

In addition, the hybrid multilayer substrate described in Claim 11 of the present invention is in accordance with Claim 10 of the present invention, in which a first chip type electronic component is placed in the cavity.

In addition, the hybrid multilayer substrate described in Claim 12 of the present invention is in accordance with Claim 11 of the present invention, in which the first chip type electronic component placed in the cavity is sealed with a resin.

In addition, the hybrid multilayer substrate described in Claim 13 of the present invention is in accordance with one of Claims 10 to 12 of the present invention, in which the ceramic substrate is a ceramic multilayer substrate composed of ceramic layers laminated to each other, and a predetermined conductive pattern is formed inside the ceramic multilayer substrate and on a surface thereof.

In addition, the hybrid multilayer substrate described in Claim 14 of the present invention is in accordance with Claim 13 of the present invention, in which the ceramic layers are each formed using a low temperature sintered ceramic layer, and the conductive pattern is formed of a conductive material primarily composed of silver or copper.

In addition, the hybrid multilayer substrate described in Claim 15 of the present invention is in accordance with Claim 13 or 14 of the present invention, in which a terminal electrode is formed in the surface of the resin portion opposite to the surface bonded to the ceramic multilayer substrate, and the terminal electrode is connected to the conductive pattern formed for the ceramic multilayer substrate via a via conductor formed in the resin portion.

In addition, the hybrid multilayer substrate described in Claim 16 of the present invention is in accordance with one of Claims 13 to 15 of the present invention, wherein a region, in which a conductive pattern is not formed at the interface between the resin portion and the ceramic substrate and on the bottom surface of the cavity, is formed from an inside wall surface of the cavity, which is used as the center, to a position 150 µm or more apart therefrom in every direction.

### Advantages

According to Claims 1 to 16 of the present invention, a hybrid multilayer substrate and a method for manufacturing the same can be provided, the hybrid multilayer substrate having high arrangement accuracy of terminal electrodes and the like provided in the bottom surface of the cavity and being capable of significantly improving the reliability in connection with a mounted component.

### Brief Description of the Drawings

Figs. 1(a) and 1(b) are views each showing one embodiment of a hybrid multilayer substrate according to the present invention; Fig. 1(a) is a cross-sectional view of the entire substrate; and Fig. 1(b) is a cross-sectional view showing the state before a chip type electronic component is sealed with a resin.
Fig. 2 (a) and 2 (b) are views each illustrating an arrangement structure of electrodes provided in a bottom surface of a cavity formed in the hybrid multilayer substrate shown in Fig. 1.
Figs. 3(a) and 3(b) are views each illustrating a step of mounting a chip type electronic component on a ceramic substrate of the hybrid multilayer substrate shown in Fig. 1.
Figs. 4(a) to 4(d) are views each illustrating a step of forming a resin portion of the hybrid multilayer substrate shown in Fig. 1.
Figs. 5(a) and 5(b) are views each illustrating a step of performing thermocompression bonding between a resin portion and a ceramic substrate of the hybrid multilayer substrate shown in Fig. 1.
Fig. 6 is a view showing an important part of another manufacturing step of the hybrid multilayer substrate shown in Fig. 1.
Fig. 7 is a cross-sectional view showing another embodiment of a hybrid multilayer substrate according to the present invention.
Fig. 8 is a cross-sectional view showing still another embodiment of a hybrid multilayer substrate according to the present invention.
Fig. 9 is a cross-sectional view showing still another embodiment of a hybrid multilayer substrate according to the present invention.
Fig. 10 is a cross-sectional view showing still another embodiment of a hybrid multilayer substrate according to the present invention.
Fig. 11 is a cross-sectional view showing a conventional multilayer substrate having a cavity before a chip type electronic component is mounted therein.

### Reference Numerals

10, 20, 30, 40, 50 hybrid multilayer substrate
10A cavity
11, 21, 31, 41, 51 resin portion
11B protrusion part
11C external terminal electrode (terminal electrode)
11E via conductor
12, 22, 32, 42, 52 ceramic multilayer substrate (ceramic substrate)
12A ceramic layer
12B penetrating hole
12C external terminal electrode (conductive pattern)
12D external terminal electrode (conductive pattern)
12E in-plane conductor (conductive pattern)
12F via conductor (conductive pattern)
13, 23, 33, 43, 53 first chip type electronic component
14A, 24A, 34A, 44A second chip type electronic component
14B, 24B, 34B, 44B second chip type electronic component
15 sealing resin portion (resin)

### Best Mode for Carrying Out the Invention

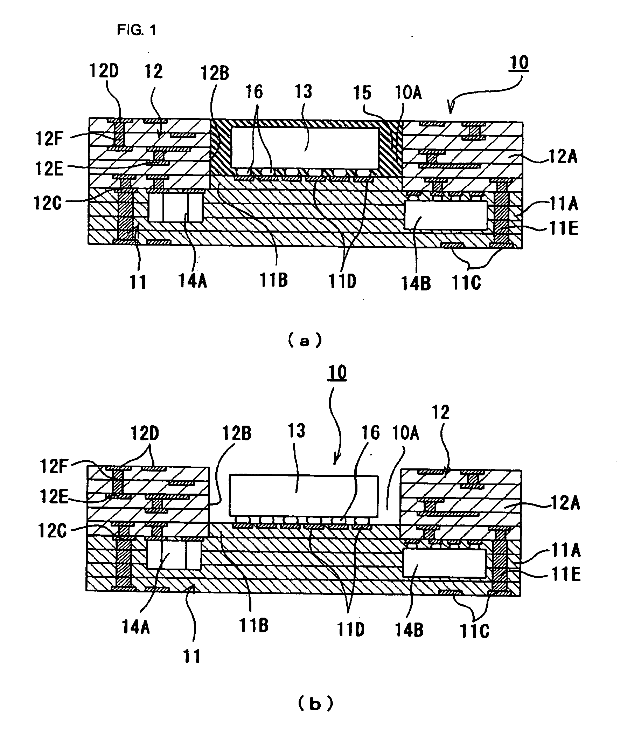

Hereinafter, the present invention will be described with reference to embodiments shown in Figs. 1 to 10.

A hybrid multilayer substrate 10 of this embodiment has, as shown in Fig. 1(a) by way of example, a cavity 10A in a laminate structure which is formed of a resin portion 11 and a ceramic substrate 12 laminated thereon, and is mounted on a mounting substrate (not shown), such as a printed circuit board, with the resin portion 11 provided therebetween. In addition, when the hybrid multilayer substrate 10 is mounted on a ceramic-made substrate, mounting may be performed with the ceramic substrate 12 provided therebetween. Since the mounting substrate, such as a printed circuit board, is made from a resin in many cases, the resin portion 11 is preferably formed of a resin having a thermal expansion coefficient between the thermal expansion coefficient of the ceramic substrate 12 and that of the mounting substrate, such as an intermediate thermal expansion coefficient therebetween, or a resin having a thermal expansion coefficient gradient therebetween. The resin portion 11 is present between the ceramic substrate 12 and the mounting substrate to reduce the difference in thermal expansion between the hybrid multilayer substrate 10 and the mounting substrate, and as a result, the hybrid multilayer substrate 10 mounted on the mounting substrate is not easily removed therefrom even in a high temperature atmosphere. This resin portion 11 is formed to have a laminate structure composed of resin layers 11A laminated to each other as shown in the figure, and the ceramic substrate 12 is formed as a ceramic multilayer substrate including ceramic layers 12A laminated to each other. Hence, hereinafter, the ceramic substrate 12 will be described as a ceramic multilayer substrate 12.

Subsequently, as shown in Fig. 1(b), a protrusion part 11B having a flat front surface is formed at a central part of the upper surface of the resin portion 11, and a penetrating hole 12B corresponding to the protrusion part 11B of the resin portion 11 is formed in the ceramic multilayer substrate 12. In addition, when the protrusion part 11B of the resin portion 11 is fitted to a bottom end part of the penetrating hole 12B of the ceramic multilayer substrate 12, the resin portion 11 and the ceramic multilayer substrate 12 are united, so that the cavity 10A of the hybrid multilayer substrate 10 is formed. The height of the protrusion part 11B may be at least 10 µm and is more preferably 50 µm or more. When the height of the protrusion part 11B is more than 500 µm, since a protrusion region under the bottom surface of the cavity 10A is a useless region, the height of the protrusion part 11B is preferably set to 500 µm or less. Since the protrusion part 11B of the resin portion 11 is fitted to the bottom end part of the penetrating hole 12B of the ceramic multilayer substrate 12, a bonding strength between the resin portion 11 and the ceramic multilayer substrate 12 can be improved, and as a result, the reliability as the hybrid multilayer substrate 10 can be enhanced.

In the cavity 10A, a first chip type electronic component 13 is provided. In addition, since second chip type electronic components 14A and 14B mounted on the bottom surface of the ceramic substrate 12 are embedded in the resin portion 11, the resin portion 11 can be further effectively used as a mounting space for the second chip type electronic components 14A and 14B, and hence functions of the hybrid multilayer substrate 10 can be increased so as to satisfy the trend toward enhancement of multifunctionality.

In addition, a resin is filled in the cavity 10A, and by this resin, the first chip type electronic component 13 is sealed. This resin portion (hereinafter referred to as a "sealing resin portion") 15 has an upper surface flush with the upper surface of the ceramic multilayer substrate 12, so that one flat surface is formed. As described above, since the first and the second chip type electronic components 13, 14A, and 14B are respectively sealed with the resins, the first and the second chip type electronic components 13, 14A, and 14B are protected from external mechanical shock, moisture, and the like.

Next, individual constituent elements of the hybrid multilayer substrate 10 will be described in more detail. First, the resin portion 11 will be described. As shown in Figs. 1(a) and 1(b), external terminal electrodes 11C are formed in the bottom surface of the resin portion 11 to have a predetermined pattern, and electrical connection to the mounting substrate is performed via the external terminal electrodes 11C. External terminal electrodes 11D having a predetermined pattern are formed in the upper surface of the protrusion part 11B of the resin portion 11 and are connected to the first chip type electronic component 13 placed in the cavity 10A. In addition, via conductors 11E are provided in the resin portion 11 and serve to connect between a conductive pattern of the ceramic multilayer substrate 12 and a conductive pattern of the mounting substrate. External terminal electrodes present at the bonding surface between the resin portion 11 and the ceramic multilayer substrate 12 are not formed at the resin portion 11 side by the reason to be described below and are formed at the ceramic multilayer substrate 12 side.

The resin layer 11A is preferably formed from a mixed resin composition containing a thermosetting resin and an inorganic filler. As the thermosetting resin, for example, an epoxy resin, a phenol resin, or a cyanate resin, which has superior heat resistance and humidity resistance, may be used, and as the inorganic filler, for example, alumina, silica, or titania may be used. By addition of the inorganic filler as described above, the thermal expansion coefficient of the resin portion 11 can be adjusted, and heat dissipation properties thereof can also be improved. In addition, the fluidity of the resin can be appropriately controlled when the resin portion 11 is manufactured.

The external terminal electrodes 11C and 11D of the resin portion 11 are formed of a metal foil such as a copper foil. The via conductor 11E is formed by filling a conductive resin in a via conduction hole formed in the resin portion 11. The conductive resin is a conductive resin composition formed, for example, of metal particles and a thermosetting resin. As the metal particles, for example, a metal, such as gold, silver, copper, or nickel, may be used, and as the thermosetting resin, for example, an epoxy resin, a phenol resin, or a cyanate resin may be used. In addition, whenever necessary, the via conductor 11E may be formed, for example, of electroless plating copper and electrolytic plating copper.

Next, the ceramicmultilayer substrate 12 will be described. As shown in Figs. 1(a) and 1(b), external terminal electrodes 12C having a predetermined pattern is formed on the bottom surface of the ceramic multilayer substrate 12, and the ceramic multilayer substrate 12 is connected to the via conductors 11E of the resin portion 11 via the external terminal electrodes 12C. External terminal electrodes 12D having a predetermined pattern are formed in the upper surface of the ceramic multilayer substrate 12, and a third chip type electronic component (not shown) can be mounted via the external terminal electrodes 12D. Furthermore, in-plane conductors 12E having a predetermined pattern are formed in the individual ceramic layers 12A of the ceramic multilayer substrate 12, and the in-plane conductors 12E adjacent in an up and down direction are connected to each other via conductors 12F having a predetermined pattern. The external terminal electrodes 12C and 12D, the in-plane conductors 12E, and the via conductors 12F are connected to each other, so that a conductive pattern of the ceramic multilayer substrate 12 is formed.

The ceramic layer 12A is formed of a ceramic material. Although the ceramic material is not particularly limited, for example, a low temperature sintered ceramic (LTCC: Low Temperature Co-fired Ceramic) material may be preferably used. The low temperature sintered ceramic is a ceramic material which can be fired at a temperature of 1, 050°C or less. As the low temperature sintered ceramic material, for example, there may be mentioned a glass composite-based LTCC material containing powdered ceramic, such asalumina,forsterite, orcordierite, andborosilicateglass mixed therewith; a crystalline glass-based LTCC material using a ZnO-MgO-Al₂O₃-SiO₂-based crystalline glass; or a non-glass-based LTCC material using a powdered BaO-Al₂O₃-SiO₂-based ceramic, a powdered Al₂O₃-CaO-SiO₂-MgO-B₂O₃-based ceramic, or the like.

When a low temperature sintered ceramic material is used for the ceramic multilayer substrate 12, as a conductive material for the external terminal electrodes 12C, 12D, and the like for example, a metal, such as silver (Ag), copper (Cu), or gold (Au), having a low resistance and a low melting point can be used and can be fired at a low temperature simultaneously with the ceramic layers 12A so as to be united therewith. Hence, the conductive patterns of the external terminal electrodes 12C, 12D, and the like are formed of a sintered metal. In addition, by using the low temperature sintered ceramic material, a passive element, such as a capacitor or an inductor, which is formed of a ceramic sintered body used as a base body obtained by firing at a temperature higher than that of the low temperature sintered ceramic material, can be embedded in the ceramic multilayer substrate 12.

Since the ceramic multilayer substrate 12 is formed of a low temperature sintered ceramic material as described above and has a surface roughness Rmax (several micrometers) approximately equivalent to that of a copper foil, the bonding force to the resin portion 11 is not strong. Hence, in this embodiment, the external terminal electrode 12C connecting between the ceramic multilayer substrate 12 and the resin portion 11 is formed of a sintered metal as described above. The sintered metal forming the external terminal electrode 12C has a surface roughness Rmax of several tens of micrometers, which is larger by one order of magnitude than that of a copper foil which has a surface roughness Rmax of several micrometers, and hence the bonding force to the resinportion 11 can be increased by an anchor effect of the sintered metal. The difference in surface roughness as described above is because of the following reason. The copper foil is formed by plating or rolling of a copper sheet, and on the other hand, the sinteredmetal is formed by firing a conductive paste containing 10% to 40% of a resin component on a volume ratio basis; hence, the resin component is burned out to form voids inside or on the surface, and as a result, the surface roughness is increased.

The first chip type electronic component 13 is placed on and connected to the external terminal electrodes 11D formed in the upper surface of the protrusion part 11B of the resin portion 11 via solder balls 16. Since the protrusion part 11B of the resin portion 11 is fitted in the penetrating hole 12B of the ceramic multilayer substrate 12, when the resin portion 11 and the ceramic multilayer substrate 12 are thermocompression-bonded together, the protrusion part 11B is held by the penetrating hole 12B so that the flow of the resin of the protrusion part 11B is prevented or suppressed, and as a result, the shift in position of the external terminal electrodes 11D formed in the upper surface of the protrusion part 11B can be prevented or suppressed as small as possible. Hence, the external terminal electrodes 11D located at a mounting surface for the first chip type electronic component 13 can be formed almost as designed to be disposed with high accuracy. As the first chip type electronic component 13, for example, an active chip component, such as a semiconductor chip, or a passive chip component, such as a laminate capacitor or a laminate inductor, may be provided.

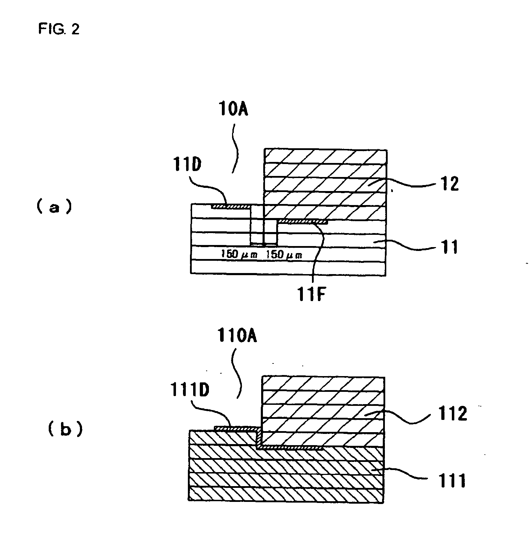

In addition, as shown in Fig. 2 (a), at the interface between the resin portion 11 and the ceramic multilayer substrate 12 and on the bottom surface of the cavity 10A, a region, in which a conductive pattern of the external terminal electrodes 11D is not formed, is formed to be extended from the inside wall surface of the cavity 10A, which is used as the center, to a position 150 µm or more apart therefrom in every direction. As shown in Fig. 2(b), when it is assumed that a conductive pattern is continuously formed in an area extended from the inside wall surface of a cavity 110A, which is used as the center, to a position less than 150 µm apart therefrom in everydirection, a conductive pattern 111Dmay be cut off when a resin portion 111 and a ceramic multilayer substrate 112 are thermocompression-bonded, or wire breakage may occur by bending, resulting in conduction failure. In addition, as shown in Fig. 2 (a), when it is assumed that a conductive pattern 11F of the resin portion 11 is present at the interface between the resin portion 11 and the ceramic multilayer substrate 12, since the conductive pattern 11F of the resin portion 11 is formed from a copper foil, the bonding force between the resin portion 11 and the ceramic multilayer substrate 12 is decreased, and in addition, moisture is liable to enter through the interface between the portion 11 and the substrate 12; hence, the reliability may be degraded in some cases.

In addition, since the second chip type electronic components 14A and 14B are embedded in the resin portion 11 which is not necessarily to be fired, besides passive chip components, active chip components can be provided in the resin portion 11 as the second chip type electronic components 14A and 14B, and hence the enhancement of multifunctionality can be facilitated. In this embodiment, as the second chip type electronic component 14A, for example, a passive chip component, such as a laminate capacitor or a laminate inductor, is provided, and as the second chip type electronic component 14B, for example, an active chip component, such as a semiconductor chip, is provided.

In addition, as is the case of the resin portion 11, a resin forming a sealing resin portion 15 is preferably formed of a mixed resin composition containing a thermosetting resin and an inorganic filler.

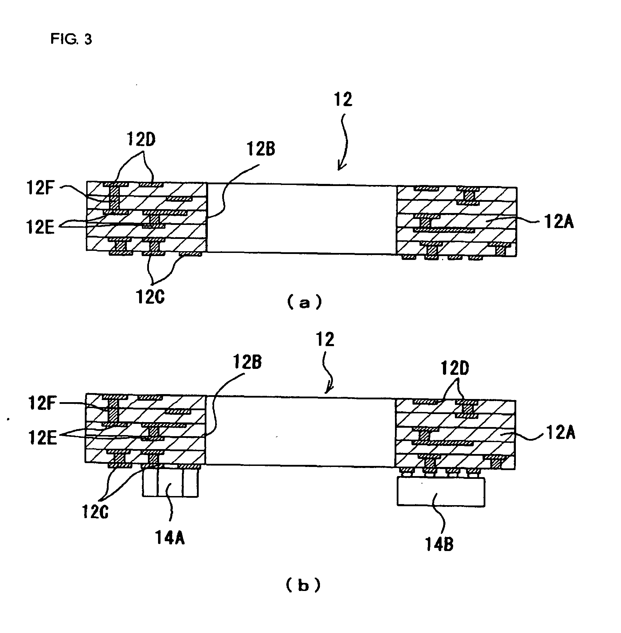

Next, a method for manufacturing the hybrid multilayer substrate 10 shown in Fig. 1 will be described with reference to Figs. 3 to 6. First, a method for forming a ceramic multilayer substrate 11 will be described. A slurry containing, for example, a low temperature sintered ceramic material is first applied on resin films made of PET or the like and is then dried, so that a predetermined number of ceramic green sheets having a thickness of approximately 10 to 200 µm are formed.

Next, by using a die or laser light, a plurality of via conduction holes having a diameter of approximately 0.1 mm are formed in the ceramic green sheets to have a predetermined pattern. In addition, for example, a conductive paste prepared by compounding a powdered metal primarily composed of Ag or Cu, a resin, and an organic solvent is filled in the via conduction holes in the ceramic green sheets, followed by drying, so that via conduction portions are formed. Furthermore, the same type conductive paste as described above is printed on the ceramic green sheet to form a predetermined pattern by a screen printing method, followed by drying, so that plane conduction portions used as a surface electrode and an in-plane conductor are formed. In the same manner as described above, via conduction portions and plane conduction portions are formed in the other ceramic green sheets. Penetrating holes for the cavity 12B are formed in the above ceramic green sheets using a die, laser light, or the like.

Next, after a predetermined number of the ceramic green sheets formed as described above are laminated to each other, thermocompression bonding is performed at a predetermined pressure, such as 0.1 to 1.5 MPa, and at a temperature of 40 to 100°C, so that a green ceramic multilayer substrate having a penetrating hole for the cavity 10A is formed. This green ceramic multilayer substrate is fired, so that the ceramic multilayer substrate 12 having the penetrating hole 12B shown in Fig. 3(a) is obtained. When a Ag-based conductive paste is used, the green ceramic multilayer substrate is fired in air at approximately 850°C, and when a Cu-based conductive paste is used, the green ceramic multilayer substrate is fired in an nitrogen gas at approximately 950°C. After the ceramic multilayer substrate 12 is obtained, whenever necessary, films are formed, for example, by wet plating of Ni/Sn, Ni/Au, or the like on the surfaces of the external terminal electrodes 12C and 12D which are exposed at the top and the bottom surfaces of the ceramic multilayer substrate 12. By the sequential steps described above, the ceramic multilayer substrate 12 shown in Fig. 3(a) is obtained.

Subsequently, after the external terminal electrodes 12C on the bottom surface of the ceramic multilayer substrate 12 and the second chip type electronic components 14A and 14B are aligned, the second chip type electronic components 14A and 14B are mounted on the ceramic multilayer substrate 12 with a bonding material, such as solder, provided therebetween as shown in Fig. 3(b).

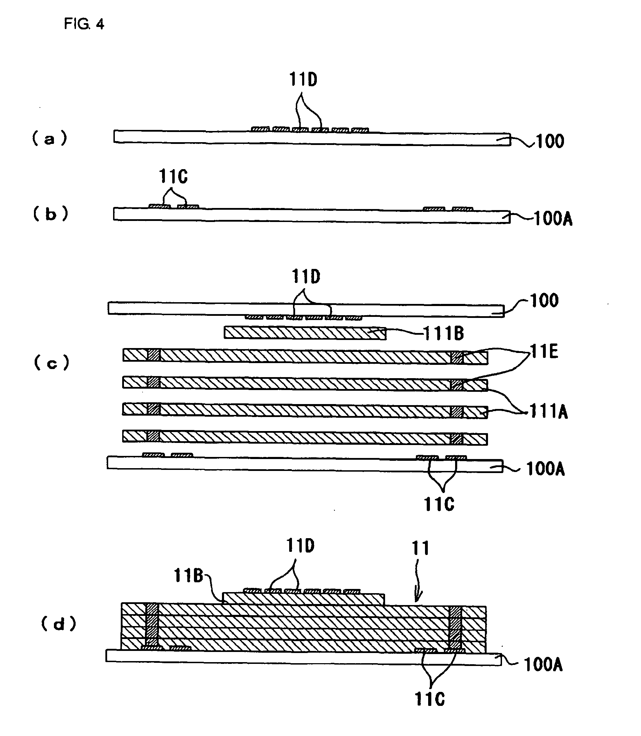

In addition, the resin portion 11 is formed as shown in Fig. 4. The external terminal electrodes 11D located at the protrusion part 11B of the resin portion 11, that is, which is used as the bottom surface of the cavity 10A, and the external terminal electrodes 11C located at the bottom surface of the resin portion 11 are formed. For this formation, after a metal foil, such as a copper foil, having a thickness of approximately 10 to 40 µm is adhered to a support 100 made of PET or the like as shown in Fig. 4(a), a resist layer is formed on the copper foil by applying a photoresist and is then exposed using a predetermined pattern, and subsequently an unnecessary resist layer is removed by development. Then, after an unnecessary copper foil portion is removed by an etching treatment, a resist film is peeled away, so that as shown in the above figure, the external terminal electrodes 11D are formed on the support 100 to have a predetermined pattern. The external terminal electrodes 11D are formed so as to be located in a region at least 150 µm apart from the periphery of the protrusion part 11B of the resin portion 11. In addition, in a manner similar to that described above, the external terminal electrodes 11C are formed on a support 100A made of a PET or the like so as to have a predetermined pattern as shown in Fig. 4 (b).

Next, as shown in Fig. 4 (c), a predetermined number of resin sheets 111A in a prepreg state obtained by mixing a thermosetting resin, such as an epoxy resin, and an inorganic filler, such as alumina, are formed, and in addition, a resin sheet 111B to be formed into the protrusion part 11B is also formed. Via conduction holes having a predetermined pattern are formed in the resin sheets 111A using laser light or the like, and a conductive resin is filled in these via conduction holes, so that the via conductors 11E are formed. Subsequently, as shown in Fig. 4(c), after a support 110A having the external terminal electrodes 11C, a predetermined number of the resin sheets 111A having the via conductors 11E, the resin sheet 111B, and the support 100 having the external terminal electrodes 11D are laminated in that order while alignment therebetween is being performed, compression bonding is performed at a predetermined pressure, followed by removing the support 100. Accordingly, as shown in Fig. 4(d), the external terminal electrodes 11D on the support 100 are transferred to the resin sheet 111B, and hence the resin portion 11 having the protrusion part 11B can be obtained.

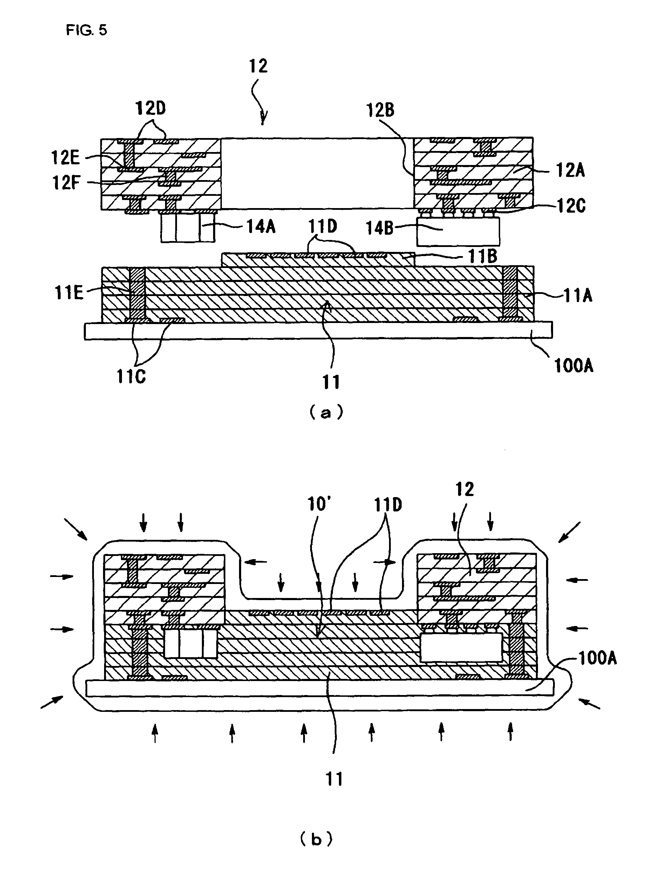

Subsequently, as shown in Fig. 5(a), when the penetrating hole 12B of the ceramic multilayer substrate 12 and the protrusion part 11B of the resin portion 11 are aligned at the upper side of the resin portion 11 provided on the support 100A and are then thermocompression-bonded at a thermosetting temperature of the resin, the protrusion part 11B is fitted to the penetrating hole 12B, and in addition, the second chip type electronic components 14A and 14B are embedded in the resin portion 11. In this step, since the protrusion part 11B is held by the penetrating hole 12B, the resin forming the protrusion part 11B substantially does not flow, and a resin other than that of the protrusion part 11B flows and forms the resin portion 11. Hence, the external terminal electrodes 11D of the protrusion part 11B does not substantially shift in the horizontal direction, and as a result, a flat pattern can be formed almost as designed. When the thermocompression bonding is performed, a vacuum laminator or the like is preferably used as shown in Fig. 5(b) in which a flexible member or the like performs isotropic pressing in conformity with the shape of the laminate formed of the resin portion 11 and the ceramic multilayer substrate 12. When the isotropic pressing is performed, by supporting the laminate by a flat member (support 100A) such as a metal plate as shown in Fig. 5 (b), a hybrid multilayer substrate 10' can be obtained which has superior flatness and which is made of the resin portion 11 and the ceramic multilayer substrate 12.

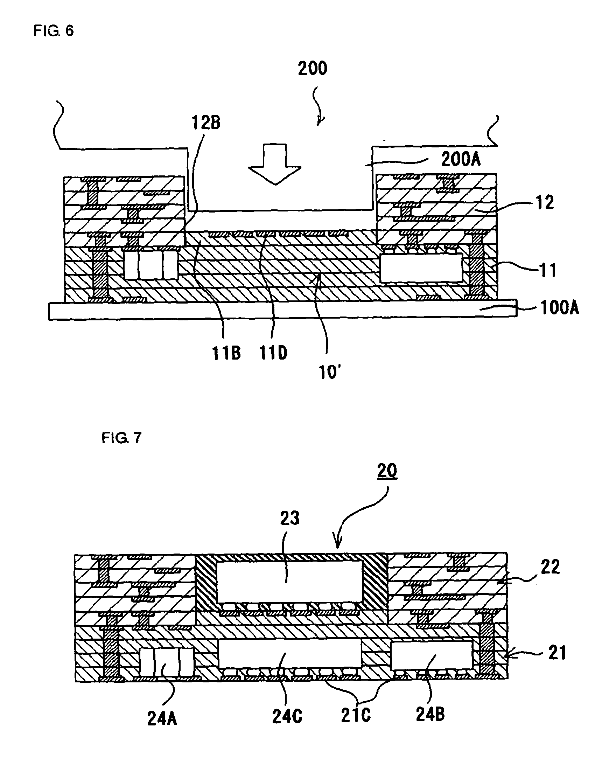

In addition, when a press mold 200 having a protrusion part 200A is used as shown in Fig. 6 instead of the isotropic pressing, and when pressing is performed while the protrusion part 200A is fitted to the penetrating hole 12B of the ceramic multilayer substrate 12, the resin portion 11 and the ceramic multilayer substrate 12 can be thermocompression-bonded. In this step, since the external terminal electrodes 11D provided in the upper surface of the protrusion part 11B of the resin portion 11 are formed ina region at least 150 µm apart from the periphery of the protrusion part 11B, the external terminal electrodes 11D and the like may not be damaged. In addition, when a multistage press mold having a plurality of protrusion steps is used as the press mold, the protrusion part 11B of the resin portion 11 can be formed to have a plurality of steps.

Next, the first chip type electronic component 13 such as a semiconductor chip is mounted in the cavity 10A of the hybrid multilayer substrate 10'. In this step, since the mounting surface for the first chip type electronic component 13 is formed from the resin to be flat without having any steps, and in addition, the external terminal electrodes 11D are not shifted, the posture of the first chip type electronic component 13 in the cavity 10A is stable, and hence the first chip type electronic component 13 can be reliably mounted with high accuracy without causing any connection failures and the like. In addition, when flip chip connection is performed, chipping will not occur, and when reflow is performed, mounting can be performed with high accuracy by self-alignment.

After the first chip type electronic component 13 is mounted, a resin is filled in a gap formed in the cavity 10A, and after the first chip type electronic component 13 is sealed as shown in Fig. 1(a), a predetermined heat treatment is performed, so that the sealing resin portion 15 is formed.

As described above, according to this embodiment, since the resin portion 11 having the protrusion part 11B and the ceramic multilayer substrate 12 having the penetrating hole 12B form a laminate structure, and the cavity 10A of the hybrid multilayer substrate 10 is formed by fitting the protrusion part 11B of the resin portion 11 to the bottom end part of the penetrating hole 12B of the ceramic multilayer substrate 12, the bonding force between the resin portion 11 and the ceramic multilayer substrate 12 can be increased, and in addition, the external terminal electrodes 11D in the bottom surface of the cavity 10A can be formed almost as designed; hence, the hybrid multilayer substrate 10 can meet the trend toward reduction in size and increase in the number of pins of the first chip type electronic component 13, and the reliability as the hybrid multilayer substrate 10 can be improved. In addition, since the first chip type electronic component 13 is mounted in the cavity 10A, self-alignment mounting of the first chip type electronic component 13 can be performed. In addition, since the bottom surface of the cavity 10A is planarized by the resin, the posture of the first chip type electronic component 13 is stable on the bottom surface used as the mounting surface, and hence electrical connection by wire bonding or the like can be reliably performed. Also in the case in which flip-chip connection is performed for the first chip type electronic component 13, a plurality of connection terminals thereof can reliably reach the external terminal electrodes 11D in the protrusion part 11B and can be reliably connected thereto, and hence chipping and/or connection failures of flip-chip assembly and the like may not occur in mounting.

In addition, according to this embodiment, since the first chip type electronic component 13 is placed in the cavity 10A, reduction in height of the hybrid multilayer substrate 10 can be realized. In addition, since the first chip type electronic component 13 placed in the cavity 10A is sealed by the sealing resin portion 15, the first chip type electronic component 13 can be protected from external mechanical shock, moisture, and the like, and hence the reliability can be improved. Since the ceramic multilayer substrate 12 is formed of the ceramic layers 12A laminated to each other, and conductive patterns formed of the external terminal electrodes 12C and 12D, the in-plane conductors 12E, and the via conductors 12F are provided in the ceramic multilayer substrate 12 and on the surfaces thereof, a region surrounding the first chip type electronic component 13 can be effectively used as a wiring region, and hence the reduction in height of the hybrid multilayer substrate 10 can be facilitated.

In addition, since the resin portion 11 has the external terminal electrodes 11C in the surface opposite to the surface bonded to the ceramic multilayer substrate 12, and the external terminal electrodes 11C are connected to the external terminal electrodes 12C, that is, to the conductive pattern formed on the ceramic multilayer substrate 12, via the via conductors 11E formed in the resin portion 11, the conductive pattern of the ceramic multilayer substrate 12 and the conductive pattern of the mounting substrate can be reliably connected to each other via the via conductors 11E of the resin portion 11, and as a result, the first and the second chip type electronic components 13, 14A, and 14B can be reliably connected to the mounting substrate, so that the enhancement of multifunctionality of the substrate can be realized.

In addition, according to this embodiment, since the ceramic multilayer substrate 12 is formed of the low temperature sintered ceramic layers 12A laminated to each other, and the conductive pattern thereof is formed of a conductive material primarily composed of silver or copper, the ceramic multilayer substrate 12 and the conductive pattern can be co-fired at a low temperature of 1,050°C or less, and hence even by the low temperature firing, a conductive pattern having low resistance can be reliably formed.

In addition, since the region, in which the conductive patterns of the external terminal electrodes 11D and the like are not provided at the interface between the resin portion 11 and the ceramic multilayer substrate 12 and on the bottom surface of the cavity 10A, is formed from the inside wall surface of the cavity 10A, which is used as the center, to a position 150 µm or more apart therefrom in every direction, moisture intrusion and connection defects may not occur, and hence a highly reliable conductive pattern can be formed.

In addition, according to this embodiment, when the hybrid multilayer substrate 10 is manufactured, there are provided respective steps for forming the resin portion 11 having the protrusion part 11B and for forming the ceramic multilayer substrate 12 having the penetrating hole 12B, and the step of bonding the resin portion 11 to the ceramic multilayer substrate 12 so as to fit the protrusion part 11B of the resin portion 11 to the end part of the penetrating hole 12B of the ceramic multilayer substrate 12. Accordingly, the resin portion 11 and the ceramic multilayer substrate 12 are united to form the cavity 10A in which the upper surface of the protrusion part 11B is used as the bottom surface. As a result, the hybrid multilayer substrate 10 can be reliably manufactured.

Next, other embodiments of the hybrid multilayer substrate according to the present invention will be described with reference to Figs. 7 to 10. In the following description, characteristic portions of the embodiments will be each described using a reference numeral which is increased by 10 in each embodiment.

As is the hybrid multilayer substrate 10 shown in Fig. 1, a hybrid multilayer substrate 20 shown in Fig. 7 has a resin portion 21, a ceramic multilayer substrate 22, and first and second chip type electronic components 23, 24A, and 24B. In addition, in this embodiment, a second chip type electronic component 24C is mounted in the resin portion 21 under the first chip type electronic component 23, so that a region of the resin portion 21 under the first chip type electronic component 23 is effectively used, and in addition, the second chip type electronic components 24A, 24B, and 24C are mounted to external terminal electrodes 21C formed in the bottom surface of the resin portion 21. Except for the above two points described above, the hybrid multilayer substrate 20 has the structure similar to that of the hybrid multilayer substrate 10 shown in Fig. 1. According to this embodiment, since the region of the resin portion 21 under the first chip type electronic component 23 can be effectively used for mounting the second chip type electronic component 24C, the multifunctionality can be enhanced as compared to the hybrid multilayer substrate 10 shown in Fig. 1.

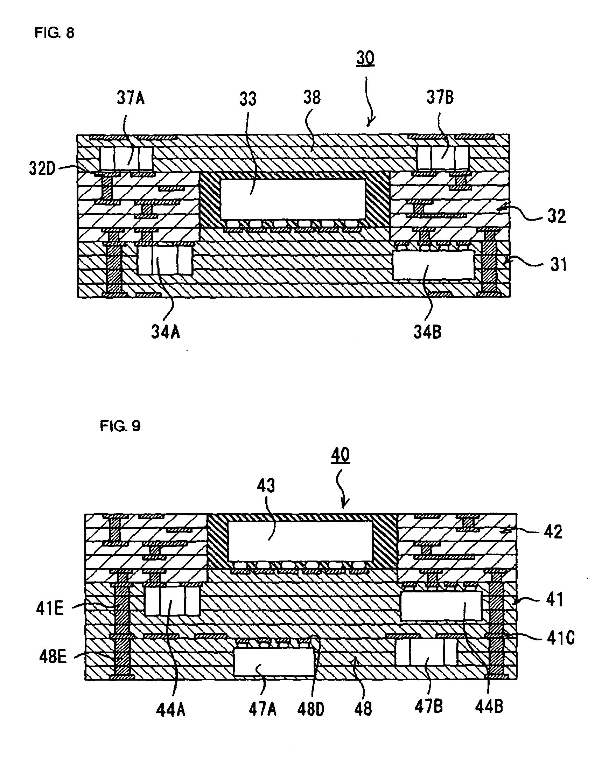

As is the hybrid multilayer substrate 10 shown in Fig. 1, a hybrid multilayer substrate 30 shown in Fig. 8 has a resin portion 31, a ceramic multilayer substrate 32, and first and second chip type electronic components 33, 34A, and 34B. In addition, the hybrid multilayer substrate 30 of this embodiment has third chip type electronic components 37A and 37B mounted on the upper surface of the ceramic multilayer substrate 32 via external terminal electrodes 32D, and a second sealing resin portion 38 sealing the third chip type electronic components 37A and 37B. Except for those points described above, the hybrid multilayer substrate 30 has the structure similar to that of the hybrid multilayer substrate 10 shown in Fig. 1. As the third chip type electronic components 37A and 37B, for example, an active chip component, such as a semiconductor chip, and a passive chip component, such as a laminate capacitor or a laminate inductor, can be mounted.

According to this embodiment, since the third chip type electronic components 37A and 37B are mounted on the surface (upper surface) of the ceramic multilayer substrate 32, compared to the case of the above embodiment, the hybrid multilayer substrate 30 can be obtained which has further enhanced multifunctionality. In addition, since being covered with the second sealing resin portion 38, the third chip type electronic components 37A and 37B can be reliably protected from exterior moisture and the like.

As is the hybrid multilayer substrate 10 shown in Fig. 1, a hybridmultilayer substrate 40 shown in Fig. 9 has a resin portion 41, a ceramic multilayer substrate 42, and first and second chip type electronic components 43, 44A, and 44B. In addition, the hybrid multilayer substrate 40 of this embodiment has a second resin portion 48 formed on the bottom surface of the resin portion 41 and third chip type electronic components 47A and 47B provided in this second resin portion 48, and the resin portion 41 and the second resin portion 48 form a resin laminate. Except that the third chip type electronic components 47A and 47B and the second resin portion 48 are provided, the hybrid multilayer substrate 40 has the structure similar to that of the hybrid multilayer substrate 10 shown in Fig. 1. For example, the resin portion 41 and the second resin portion 48 may contain the same resin component or may contain different resin components. The third chip type electronic component 47A is connected, for example, to external terminal electrodes 48D formed on an upper surface of the second resin portion 48, and the third chip type electronic component 47B is connected, for example, to external terminal electrodes 41C formed on a bottom surface of the resin portion 41. In this figure, reference numeral 48E indicates a via conductor formed in the second resin portion 48, and this via conductor 48E connects between the via conductor 41E of the resin portion 41 and a mounting substrate. As the third chip type electronic components 47A and 47B, for example, an active chip component, such as a semiconductor chip, and a passive chip component, such as a laminate capacitor or a laminate inductor, are provided. In this embodiment, effects and advantages similar to those of the hybrid multilayer substrate 30 shown in Fig. 8 can also be expected.

In addition, a hybrid multilayer substrate 50 shown in Fig. 10 includes a resin portion 51, a ceramic multilayer substrate 52, and a first chip type electronic component 53, and has the structure similar to that of the hybrid multilayer substrate 10 shown in Fig. 1 except that the first chip type electronic component 53 is connected to external terminal electrodes 52D' of the ceramic multilayer substrate 52 via bonding wires 53A. In this embodiment, a cavity 50A is formed so as to have a larger opening from a central part to the top of the inside wall surface along the height direction, and at a boundary part between the top and the bottom parts, a flat step 50B of the ceramic multilayer substrate 52 is formed. In addition, the external terminal electrodes 52D' are formed in the upper surface of this step 50B, and the external terminal electrodes 52D' are connected to the first chip type electronic component 53 via the bonding wires 53A. Also in this embodiment, since the bottom surface of the cavity 50A is formed by a protrusion part 51B of the resin portion 51 and is flat, the posture of the first chip type electronic component 53 in the cavity 50A is stable, and the first chip type electronic component 53 can be reliably connected to the external terminal electrodes 52D' of the ceramic multilayer substrate 52. In this embodiment, effects and advantages similar to those of the hybrid multilayer substrates of the above embodiments can also be expected.

The present invention is not limited to the above embodiments at all. For example, in the above embodiments, the case in which the hybrid multilayer substrate is mounted on the mounting substrate with the resin portion provided therebetween has been described; however, the mounting can be performed using the ceramic substrate therebetween. For example, in the case of the hybrid multilayer substrate 30 shown in Fig. 8, whenever necessary, either the top or the bottom surface of the hybrid multilayer substrate 30 can be connected to the mounting substrate. That is, when a hybrid multilayer substrate has a laminate structure made of a resin portion and a ceramic substrate and having a cavity, the resin portion has a protrusion part, the ceramic substrate has a penetrating hole, and the cavity is formed by fitting the protrusion part of the resin portion to an end part of the penetrating hole of the ceramic substrate, the above hybrid multilayer substrate is included in the present invention.

### Industrial Applicability

The present invention can be preferably applied, for example, to a hybrid multilayer substrate used for various electronic apparatuses.

## Claims

1. A method for manufacturing a hybrid multilayer substrate having a cavity (10A) in a laminate structure made of a resin portion *11,* 21, 31, 41, 51 and a ceramic substrate 12, 22, 32, 42, 52 , comprising the steps of:
forming a resin portion *11,* 21, 31, 41, 51 (11B) and a ceramic substrate 12, 22, 32, 42, 52 having a penetrating hole (12B); and
bonding the resin portion to the ceramic substrate 12, 22, 32, 42, 52 ;
**characterized in that**
the resin portion) *11,* 21, 31, 41, 51 has a protrusion part (11B) ; and
bonding comprises bonding the resin portion *11,* 21, 31, 41, 51 to the ceramic substrate 12, 22, 32, 42, 52 so as to fit the protrusion part (11B) of the resin portion *11,* 21, 31, 41, 51 to an end part of the penetrating hole (12B) of the ceramic substrate 12, 22, 32, 42, 52 , whereby the ceramic substrate 12, 22, 32, 42, 52 and the resin portion *11,* 21, 31, 41, 51 are united to form a cavity (10A) which uses an upper surface of the protrusion part (11B) as a bottom surface.

2. The method for manufacturing a hybrid multilayer substrate according to Claim 1, wherein the resin portion *11,* 21, 31, 41, 51 and the ceramic substration 12, 22, 32, 42, 52 are compression-bonded to each other.

3. The method for manufacturing a hybrid multilayer substrate according to Claim 1 or 2, further comprising the step of placing a first chip type electronic component 13, 23, 33, 43, 53 in the cavity (10A).

4. The method for manufacturing a hybrid multilayer substrate according to Claim 3, further comprising the step of sealing the first chip type electronic component 13, 23, 33, 43, 53 placed in the cavity (10A) with a resin.

5. The method for manufacturing a hybrid multilayersubstrate according to one of Claims 1 to 4, wherein the ceramic substrate 12, 22, 32, 42, 52 is formed as a ceramic multilayer substrate composed of ceramic layers laminated to each other, and a predetermined conductive pattern (12C-F) is formed inside the ceramic multilayer substrate and on a surface thereof.

6. The method for manufacturing a hybrid multilayer substrate according to Claim 5, wherein the ceramic layers are formed using a low temperature sintered ceramic, and as the conductive pattern (12C-F), a conductive material primarily composed of silver or copper is used.

7. The method for manufacturing a hybrid multilayer substrate according to Claim 5 or 6, wherein a terminal electrode (11C) is formed in the surface of the resin portion 11, 21, 31, 41, 51 opposite to the surface bonded to the ceramic multilayer substrate, and this terminal electrode (11C) is connected to the conductive pattern (12C-F) formed for the ceramic multilayer substrate via a via conductor (11E) formed in the resin portion 11, 21, 31, 41, 51 .

8. The method for manufacturing a hybrid multilayer substrate according to one of Claims 1 to 7, wherein a region, in which a conductive pattern (12C-F) is not formed at the interface between the resin portion 11, 21, 31, 41, 51 and the ceramic substrate 12, 22, 32, 42, 52 and on the bottom surface of the cavity (10A), is formed to be extended from an inside wall surface of the cavity (10A), which is used as the center, to a position 150 µm or more apart therefrom in every direction.

9. The method for manufacturing a hybrid multilayer substrate according to one of Claims 3 to 8, further comprising the step of placing a second chip type electronic component (14A-44A, 14B-44B in the resin portion 11, 21, 31, 41, 51 .

10. A hybrid multilayer substrate having a cavity (10A) in a laminate structure made of a resin portion 11, 21, 31, 41, 51 and a ceramic substrate 12, 22, 32, 42, 52 having a penetrating hole (12B),
**characterized in that**
the resin portion 11, 21, 31, 41, 51 has a protrusion part (11B), and
the cavity (10A) is formed of an upper surface of the protrusion part (11B) of the resin portion 11, 21, 31, 41, 51 and a wall surface of the penetrating hole (12B) of the ceramic substrate 12, 22, 32, 42, 52 .

11. The hybrid multilayer substrate according to Claim 10,
wherein a first chip type electronic component is placed in the cavity (10A).

12. The hybrid multilayer substrate according to Claim 11,
wherein the first chip type electronic component 13, 23, 33 43, 53 placed in the cavity (10A) is sealed with a resin.

13. The hybrid multilayer substrate according to one of Claims 10 to 12, wherein the ceramic substrate 12, 22, 32, 42, 52 is a ceramic multilayer substrate composed of ceramic layers laminated to each other, and a predetermined conductive pattern (12C-F) is formed inside the ceramic multilayer substrate and on a surface thereof.

14. The hybrid multilayer substrate according to Claim 13, wherein the ceramic layers are each formed using a low temperature sintered ceramic layer, and the conductive pattern (12C-F) is formed of a conductive material primarily composed of silver or copper.

15. The hybrid multilayer substrate according to Claim 13 or 14, wherein a terminal electrode (11C) is formed in the surface of the resin portion 11, 21, 31, 41, 51 opposite to the surface bonded to the ceramic multilayer substrate, and the terminal electrode (11C) is connected to the conductive pattern (12C-F) formed for the ceramic multilayer substrate via a via conductor (11E) formed in the resin portion 11, 21, 31, 41, 51 .

16. The hybrid multilayer substrate according to one of Claims 13 to 15, wherein a region, in which a conductive pattern (12C-F) is not formed at the interface between the resin portion (11-51) and the ceramic substrate 12, 22, 32, 42, 52 and on the bottom surface of the cavity (10A), is formed from an inside wall surface of the cavity (10A), which is used as the center, to a position 150 µm or more apart therefrom in every direction.

## Patentansprüche

1. Ein Verfahren zum Herstellen eines Mehrschicht-Hybridsubstrats, das einen Hohlraum (10b) in einer Laminatstruktur aufweist, die aus einem Harzabschnitt (11, 21, 31, 41, 51) und einem Keramiksubstrat (12, 22, 32, 42, 52) hergestellt ist, wobei das Verfahren folgende Schritte aufweist:
Bilden eines Harzabschnitts (11, 21, 31, 41, 51) (11B) und eines Keramiksubstrats (12, 22, 32, 42, 52), das ein Durchdringungsloch (12B) aufweist; und
Kleben des Harzabschnitts auf das Keramiksubstrat (12, 22, 32, 42, 52);
**dadurch gekennzeichnet, dass**
der Harzabschnitt (11, 21, 31, 41, 51) einen Vorsprungsteil (11B) aufweist; und
das Kleben ein Kleben des Harzabschnitts (11, 21, 31, 41, 51) auf das Keramiksubstrat (12, 22, 32, 42, 52) dahin gehend aufweist, den Vorsprungsteil (11B) des Harzabschnitts (11, 21, 31, 41, 51) an einem Endteil des Durchdringungslochs (12B) des Keramiksubstrats (12, 22, 32, 42, 52) anzubringen, wodurch das Keramiksubstrat (12, 22, 32, 42, 52) und der Harzabschnitt (11, 21, 31, 41, 51) vereinigt werden, um einen Hohlraum (10A) zu bilden, der eine obere Oberfläche des Vorsprungsteils (11B) als untere Oberfläche verwendet.

2. Das Verfahren zum Herstellen eines Mehrschicht-Hybridsubstrats gemäß Anspruch 1, bei dem der Harzabschnitt (11,21,31,41,51) und das Keramiksubstrat (12, 22, 32, 42, 52) mittels Kompression miteinander verklebt werden.

3. Das Verfahren zum Herstellen eines Mehrschicht-Hybridsubstrats gemäß Anspruch 1 oder 2, das ferner den Schritt des Platzierens einer ersten elektronischen Komponente (13, 23, 33, 43, 53) vom Chiptyp in dem Hohlraum (10b) aufweist.

4. Das Verfahren zum Herstellen eines Mehrschicht-Hybridsubstrats gemäß Anspruch 3, das ferner den Schritt des Versiegelns der in dem Hohlraum (10A) platzierten ersten elektronischen Komponente (13, 23, 33, 43, 53) vom Chiptyp mit einem Harz aufweist.

5. Das Verfahren zum Herstellen eines Mehrschicht-Hybridsubstrats gemäß einem der Ansprüche 1 bis 4, bei dem das Keramiksubstrat (12, 22, 32, 42, 52) als Mehrschicht-Keramiksubstrat gebildet ist, das aus miteinander laminierten Keramikschichten gebildet ist, und bei dem im Inneren des Mehrschicht-Keramiksubstrats und auf einer Oberfläche desselben eine vorbestimmte Leiterstruktur (12C-F) gebildet ist.

6. Das Verfahren zum Herstellen eines Mehrschicht-Hybridsubstrats gemäß Anspruch 5, bei dem die Keramikschichten unter Verwendung einer bei einer niedrigen Temperatur gesinterten Keramik gebildet werden und bei dem als Leiterstruktur (12C-F) ein leitfähiges Material verwendet wird, das vorwiegend aus Silber oder Kupfer gebildet ist.

7. Das Verfahren zum Herstellen eines Mehrschicht-Hybridsubstrats gemäß Anspruch 5 oder 6, bei dem eine Anschlusselektrode (11C) in der Oberfläche des Harzabschnitts (11, 21, 31, 41, 51) gegenüber der mit dem Mehrschicht-Keramiksubstrat verklebten Oberfläche gebildet ist und diese Anschlusselektrode (11C) über einen in dem Harzabschnitt (11, 21, 31, 41, 51) gebildeten Durchkontaktierungsleiter (11 E) mit der für das Mehrschicht-Keramiksubstrat gebildeten Leiterstruktur (12C-F) verbunden ist.

8. Das Verfahren zum Herstellen eines Mehrschicht-Hybridsubstrats gemäß einem der Ansprüche 1 bis 7, bei dem eine Region, in der keine Leiterstruktur (12C-F) an der Schnittstelle zwischen dem Harzabschnitt (11, 21, 31, 41, 51) und dem Keramiksubstrat (12, 22, 32, 42, 52) und auf der unteren Oberfläche des Hohlraums (10A) gebildet ist, dahin gehend gebildet ist, sich von einer Innenwandoberfläche des Hohlraums (10A), die als Mitte verwendet wird, zu einer Position zu erstrecken, die in jeder Richtung 150 µm oder mehr von derselben entfernt ist.

9. Das Verfahren zum Herstellen eines Mehrschicht-Hybridsubstrats gemäß einem der Ansprüche 3 bis 8, das ferner den Schritt des Platzierens einer zweiten elektronischen Komponente (14A-44A, 14B-44B) vom Chiptyp in den Harzabschnitt (11, 21, 31, 41, 51) aufweist.

10. Ein Mehrschicht-Hybridsubstrat, das einen Hohlraum (10A) in einer Laminatstruktur aufweist, die aus einem Harzabschnitt (11, 21, 31, 41, 51) und einem Keramiksubstrat (12, 22, 32, 42, 52), das ein Durchdringungsloch (12B) aufweist, hergestellt ist, **dadurch gekennzeichnet, dass**
der Harzabschnitt (11, 21, 31, 41, 51) einen Vorsprungsteil (11B) aufweist, und
der Hohlraum (10b) auf einer oberen Oberfläche des Vorsprungsteils (11B) des Harzabschnitts (11, 21, 31, 41, 51) und einer Wandoberfläche des Durchdringungslochs (12B) des Keramiksubstrats (12, 22, 32, 42, 52) gebildet ist.

11. Das Mehrschicht-Hybridsubstrat gemäß Anspruch 10, bei dem eine erste elektronische Komponente (13, 23, 33, 43, 53) vom Chiptyp in dem Hohlraum (10A) platziert ist.

12. Das Mehrschicht-Hybridsubstrat gemäß Anspruch 11, bei dem die in dem Hohlraum (10A) platzierte erste elektronische Komponente (13, 23, 33, 43, 53) vom Chiptyp mit einem Harz versiegelt ist.

13. Das Mehrschicht-Hybridsubstrat gemäß einem der Ansprüche 10 bis 12, bei dem das Keramiksubstrat (12, 22, 32, 42, 52) ein Mehrschicht-Keramiksubstrat ist, das aus miteinander laminierten Keramikschichten gebildet ist, und bei dem im Inneren des Mehrschicht-Keramiksubstrats und auf einer Oberfläche desselben eine vorbestimmte Leiterstruktur (12C-F) gebildet ist.

14. Das Mehrschicht-Hybridsubstrat gemäß Anspruch 13, bei dem die Keramikschichten jeweils unter Verwendung einer bei einer niedrigen Temperatur gesinterten Keramikschicht gebildet werden und die Leiterstruktur (12C-F) aus einem leitfähigen Material gebildet ist, das vorwiegend aus Silber oder Kupfer gebildet ist.

15. Das Mehrschicht-Hybridsubstrat gemäß Anspruch 13 oder 14, bei dem eine Anschlusselektrode (11C) in der Oberfläche des Harzabschnitts (11, 21, 31, 41, 51) gegenüber der mit dem Mehrschicht-Keramiksubstrat verklebten Oberfläche gebildet ist und die Anschlusselektrode (11C) über einen in dem Harzabschnitt (11, 21, 31, 41, 51) gebildeten Durchkontaktierungsleiter (11E) mit der für das Mehrschicht-Keramiksubstrat gebildeten Leiterstruktur (12C-F) verbunden ist.

16. Das Mehrschicht-Hybridsubstrat gemäß einem der Ansprüche 13 bis 15, bei dem eine Region, in der keine Leiterstruktur (12C-F) an der Schnittstelle zwischen dem Harzabschnitt (11, 21, 31, 41, 51) und dem Keramiksubstrat (12, 22, 32, 42, 52) und auf der unteren Oberfläche des Hohlraums (10A) gebildet ist, von einer Innenwandoberfläche des Hohlraums (10A), die als Mitte verwendet wird, zu einer Position gebildet ist, die in jeder Richtung 150 µm oder mehr von derselben entfernt ist.

## Revendications

1. Procédé de fabrication d'un substrat multicouche hybride présentant une cavité (10A) dans une structure stratifiée constituée d'une portion de résine (11, 21, 31, 41, 51) et d'un substrat céramique (12, 22, 32, 42, 52), comprenant les étapes consistant à :
former une portion de résine (11, 21, 31, 41, 51) (11B) et un substrat céramique (12, 22, 32, 42, 52) présentant un trou pénétrant (12B) ; et
lier la portion de résine au substrat céramique (12, 22, 32, 42, 52) ;
**caractérisé en ce que**
la portion de résine (11, 21, 31, 41, 51) présente une partie en saillie (11B) ; et
la liaison consiste à lier la portion de résine (11, 21, 31, 41, 51) au substrat céramique (12, 22, 32, 42, 52) de sorte à ajuster la partie en saillie (11B) de la portion de résine (11, 21, 31, 41, 51) à une partie d'extrémité du trou pénétrant (12B) du substrat céramique (12, 22, 32, 42, 52), moyennant quoi le substrat céramique (12, 22, 32, 42, 52) et la portion de résine (11, 21, 31, 41, 51) sont unis pour former une cavité (10A) qui utilise une surface supérieure de la partie en saillie (11B) en tant que surface inférieure.

2. Procédé de fabrication d'un substrat multicouche hybride selon la revendication 1, dans lequel la portion de résine (11, 21, 31, 41, 51) et le substrat céramique (12, 22, 32, 42, 52) sont liés par compression l'un à l'autre.

3. Procédé de fabrication d'un substrat multicouche hybride selon la revendication 1 ou 2, comprenant en outre l'étape consistant à placer un premier composant électronique de type puce (13, 23, 33, 43, 53) dans la cavité (10A).

4. Procédé de fabrication d'un substrat multicouche hybride selon la revendication 3, comprenant en outre l'étape consistant à sceller le composant électronique de type puce (13, 23, 33, 43, 53) placé dans la cavité (10A) avec une résine.

5. Procédé de fabrication d'un substrat multicouche hybride selon l'une des revendications 1 à 4, dans lequel le substrat céramique (12, 22, 32, 42, 52) est formé en tant que substrat multicouche céramique composé de couches de céramique stratifiées les unes sur les autres, et un motif conducteur prédéterminé (12C-F) est formé à l'intérieur du substrat multicouche céramique et sur une surface de celui-ci.

6. Procédé de fabrication d'un substrat multicouche hybride selon la revendication 5, dans lequel les couches de céramique sont formées en utilisant une céramique frittée à basse température, et en tant que motif conducteur (12C-F), un matériau conducteur principalement composé d'argent et de cuivre est utilisé.

7. Procédé de fabrication d'un substrat multicouche hybride selon la revendication 5 ou 6, dans lequel une électrode terminale (11C) est formée dans la surface de la portion de résine (11, 21, 31, 41, 51) opposée à la surface liée au substrat multicouche céramique, et cette électrode terminale (11C) est connectée au motif conducteur (12C-F) formé pour le substrat multicouche en céramique via un conducteur d'interconnexion (11E) formé dans la portion de résine (11, 21, 31, 41, 51).

8. Procédé de fabrication d'un substrat multicouche hybride selon l'une des revendications 1 à 7, dans lequel une région, dans laquelle un motif conducteur (12C-F) n'est pas formé au niveau de l'interface entre la portion de résine (11, 21, 31, 41, 51) et le substrat céramique (12, 22, 32, 42, 52) et sur la surface inférieure de la cavité (10A), est formée de sorte à s'étendre depuis une surface de paroi intérieure de la cavité (10A), qui est utilisée comme centre, jusqu'à une position espacée de 150 µm ou plus de celle-ci dans toutes les directions.

9. Procédé de fabrication d'un substrat multicouche hybride selon l'une des revendications 3 à 8, comprenant l'étape consistant à placer un second composant électronique de type puce (14A-44A, 14B-44B) dans la portion de résine (11, 21, 31, 41, 51).

10. Substrat multicouche hybride présentant une cavité (10A) dans une structure stratifiée constituée d'une portion de résine (11, 21, 31, 41, 51) et d'un substrat céramique (12, 22, 32, 42, 52) présentant un trou pénétrant (12B),
**caractérisé en ce que**
la portion de résine (11, 21, 31, 41, 51) présente une partie en saillie (11B), et
la cavité (10A) est formée d'une surface supérieure de la partie en saillie (11B) de la portion de résine (11, 21, 31, 41, 51) et d'une surface de paroi du trou pénétrant (12B) du substrat céramique (12, 22, 32, 42, 52).

11. Substrat multicouche hybride selon la revendication 10, dans lequel un premier composant électronique de type puce (13, 23, 33, 43, 53) est placé dans la cavité (10A).

12. Substrat multicouche hybride selon la revendication 11, dans lequel le premier composant électronique de type puce (13, 23, 33, 43, 53) placé dans la cavité (10A) est scellé avec une résine.

13. Substrat multicouche hybride selon l'une des revendications 10 à 12, dans lequel le substrat céramique (12, 22, 32, 42, 52) est un substrat multicouche céramique composé de couches de céramique stratifiées les unes sur les autres, et un motif conducteur prédéterminé (12C-F) est formé à l'intérieur du substrat multicouche céramique et sur une surface de celui-ci.

14. Substrat multicouche hybride selon la revendication 13, dans lequel les couches de céramique sont chacune formées en utilisant une couche de céramique frittée à basse température, et le motif conducteur (12C-F) est formé d'un matériau conducteur principalement composé d'argent et de cuivre.

15. Substrat multicouche hybride selon la revendication 13 ou 14, dans lequel une électrode terminale (11C) est formée dans la surface de la portion de résine (11, 21, 31, 41, 51) opposée à la surface liée au substrat multicouche céramique, et l'électrode terminale (11C) est connectée au motif conducteur (12C-F) formé pour le substrat multicouche en céramique via un conducteur d'interconnexion (11E) formé dans la portion de résine (11, 21, 31, 41, 51).

16. Substrat multicouche hybride selon l'une des revendications 13 à 15, dans lequel une région, dans laquelle un motif conducteur (12C-F) n'est pas formé au niveau de l'interface entre la portion de résine (11 - 51) et le substrat céramique (12, 22, 32, 42, 52) et sur la surface inférieure de la cavité (10A), est formée de sorte à s'étendre depuis une surface de paroi intérieure de la cavité (10A), qui est utilisée comme centre, jusqu'à une position espacée de 150 µm ou plus de celle-ci dans toutes les directions.
